# EUROPÄISCHE PATENTSCHRIFT

(11) **EP 3 465 126 B1**
(45) Veröffentlichungstag und Bekanntmachung des Hinweises auf die Patenterteilung: **12.08.2020**
(21) Anmeldenummer: 17729812.2
(22) Anmeldetag: 29.05.2017
(51) Int. Cl.: G01M 13/025, H05K 9/00, G01M 15/02

(54) **VORRICHTUNG UND VERFAHREN ZUM ÜBERPRÜFEN EINES BAUTEILS AUF VORHANDENSEIN EINER VORGEGEBENEN SOLL-BESCHAFFENHEIT**
DEVICE AND METHOD FOR CHECKING A COMPONENT FOR THE EXISTENCE OF A PREDETERMINED TARGET CONDITION
DISPOSITIF ET PROCÉDÉ DE CONTRÔLE D'UNE PIÈCE QUANT À LA PRÉSENCE D'UN ÉTAT DE CONSIGNE PRÉDÉFINI

(30) Priorität: 02.06.2016 DE 102016110243
(43) Veröffentlichungstag der Anmeldung: 10.04.2019
(73) Patentinhaber: Huellmandel, Steven, 92699 Bechtsrieth (DE)
(72) Erfinder: Huellmandel, Steven, 92699 Bechtsrieth (DE)
(74) Vertreter: Benninger, Johannes
(86) Internationale Anmeldenummer: PCT/EP2017/062858
(87) Internationale Veröffentlichungsnummer: WO 2017/207470

(56) Entgegenhaltungen:
- WO-A2-2010/142259
- DE-A1-102012 212 886
- US-B1- 6 597 255

## Beschreibung

Die vorliegende Erfindung betrifft eine Vorrichtung zum Überprüfen eines Bauteils auf Vorhandensein einer vorgegebenen Soll-Beschaffenheit mit den Merkmalen des unabhängigen Anspruchs 1 und ein Verfahren zum Überprüfen eines Bauteils auf Vorhandensein einer vorgegebenen Soll-Beschaffenheit mit den Merkmalen des unabhängigen Verfahrensanspruchs 9.

Im Rahmen der elektromagnetischen Verträglichkeitsprüfung werden Bauteile bzw. Prüflinge auf eine vorgegebene Soll-Beschaffenheit geprüft. Insbesondere geht es darum, die elektromagnetische Verträglichkeit des Prüflings zu charakterisieren. Die Bauteile bzw. die Prüflinge müssen einem bestimmten Wert entsprechen bzw. eine vorgegebene Soll-Beschaffenheit erfüllen. Im Rahmen der elektromagnetischen Verträglichkeitsprüfung wird sowohl die Aussendung von Störungen vom Prüfling, genannt Störaussendung, als auch die Unempfindlichkeit gegenüber von außen auftretenden Störungen auf den Prüfling, genannt Störfestigkeit, überprüft.

Bei den zu überprüfenden Bauteilen bzw. den Prüflingen kann es sich um Antriebe jeglicher Art, insbesondere um Hybridantriebe von Personenkraftwagen handeln. Im Rahmen einer Prüfung muss dem Bauteil bzw. dem Prüfling ein Drehmoment mit einer Drehzahl abgenommen bzw. aufgebürdet werden, was mit einer entsprechenden Antriebseinheit umgesetzt wird. Da die Störungen der Antriebseinheit das Ergebnis der elektromagnetischen Verträglichkeitsprüfung beeinflussen können, kann die Antriebseinheit als solche insbesondere durch einen faradayschen Käfig umhüllt bzw. selbst als faradayscher Käfig ausgebildet werden. Für den notwendigen Antrieb des Bauteils bzw. des Prüflings kann der faradaysche Käfig der Antriebseinheit sinnvollerweise eine Öffnung zur Durchführung einer Welle aufweisen. Allerdings kann bei einer solchen Anordnung die Welle in einen störbehafteten Arbeitsraum der Antriebseinheit ragen und als Antenne zur Übertragung von Störungen fungieren; d.h. die im Arbeitsraum der Antriebseinheit auftretenden Störungen können von der Antenne aufgekoppelt werden und diese nach außen abstrahlen sowie auf das Bauteil bzw. auf den Prüfling übertragen.

Um Abhilfe in Bezug auf die Übertragung von Störungen aus dem Arbeitsraum der Antriebseinheit bzw. die Antennenwirkung der Welle zu schaffen, kann bspw. ein vorzugsweise großflächiger Kontakt der Welle mit einem leitfähigen Material hergestellt werden. Als verwendete Materialien für solche Konfigurationen kommen insbesondere solche in Frage, die metallisch federnde Eigenschaften aufweisen. Ein wesentlicher Nachteilig besteht jedoch darin, dass ein solches leitfähige Material aufgrund der flächigen Berührung mit der Welle einem relativ hohen Verschleiß unterliegt.

Aus der DE 10 2012 212 886 A1 ist ein mobiler Prüfstandsaufbau zur Durchführung von EMV-Messungen bekannt. Hierbei wird ein erster Antriebsmotor eines ersten Antriebssystem Prüflings durch ein Prüfstandantriebssystem betrieben. Das Prüfstandantriebssystem ist in einer fahrbaren Palettenkonstruktion mit einer EMV-Abschirmung integriert. Außerdem kann diese fahrbare Palettenkonstruktion mit einer zweiten fahrbaren Palettenkonstruktion kombiniert werden, wobei der erste Antriebsmotor auf der ersten fahrbaren Palettenkonstruktion mit einem zweiten Antriebsmotor eines zweiten Antriebssystem-Prüflings auf der zweiten Palettenkonstruktion mechanisch gekoppelt wird. Ein solcher Prüfstandsaufbau soll der Prüfung von Antriebsystemen von Hybridfahrzeugen dienen.

Die US 6 597 255 B1 offenbart ein Kraftübertragungssystem für eine innerhalb eines Faradaykäfigs angeordnete Antriebsquelle. Das System ist dazu geeignet, Kraft von einer externen Kraftquelle an einen internen Generator zu übertragen, der sich zur Abschirmung elektromagnetischer Störeinflüsse innerhalb eines faradayschen Käfigs befindet.

Eine weiteres Kraftübertragungsvorrichtung geht aus der US 8 460 117 B2 hervor. Die rotierende Kraftübertragung durchdringt eine Abschirmung, die elektromagnetische Wellen an der Ausbreitung hindert.

WO 2010/142259 A2 offenbart einen Wellenprüfstand in dem die Welle mittels Lagern gelagert ist. Es ist keine EMV-Abschirmung vorgesehen.

US 6,597,255 B1 offenbart eine EMV-Abschirmung für ein Energietransfersystem, welches ein leitfähiges Fluid zur Abschirmung verwendet.

Der vorliegenden Erfindung liegt die Aufgabe zugrunde, eine verbesserte Vorrichtung sowie ein Verfahren zum Überprüfen eines Bauteils auf Vorhandensein einer vorgegebenen Soll-Beschaffenheit zur Verfügung zu stellen, bei welcher Störungen von einer Antriebseinheit sowie eine Antennenwirkung der Welle unterbunden werden. Die Vorrichtung soll einen einfachen Aufbau besitzen, und das Verfahren soll auf einfachste Art und Weise durchgeführt werden. Es sollen die Nachteile des Standes der Technik zumindest teilweise unterbunden bzw. ausgeglichen werden.

Diese Aufgaben werden durch eine Vorrichtung zum Überprüfen eines Bauteils auf Vorhandensein einer vorgegebenen Soll-Beschaffenheit mit den Merkmalen des unabhängigen Anspruchs 1 und durch ein Verfahren zum Überprüfen eines Bauteils auf Vorhandensein einer vorgegebenen Soll-Beschaffenheit mit den Merkmalen des unabhängigen Verfahrensanspruchs gelöst. Weitere vorteilhafte Ausgestaltungen werden durch die Unteransprüche beschrieben.

Zur Lösung der genannten Aufgabe schlägt die Erfindung eine Vorrichtung zum Überprüfen eines Bauteils auf Vorhandensein einer vorgegebenen Soll-Beschaffenheit vor. Die Vorrichtung umfasst wenigstens zwei zueinander beabstandete Lagerungen zur drehenden Aufnahme des Bauteils. Bei dem Bauteil kann es sich um Antriebe jeglicher Art handeln, wobei es sich bei dem Bauteil insbesondere um einen Hybridantrieb eines Personenkraftwagens handelt. Das Bauteil kann insbesondere eine Welle umfassen, welche von den zumindest zwei zueinander beabstandeten Lagerungen gelagert wird. Die Welle kann mit wenigstens einer Antriebseinheit gekoppelt sein, über welche die Welle und damit auch das Bauteil zu einer Drehbewegung mit einem definierten Moment und einer definierten Leistung angetrieben oder gebremst werden können. Die wenigstens eine Antriebseinheit bzw. das Gehäuse der wenigstens einen Antriebseinheit kann einen faradayschen Käfig umfassen bzw. ausbilden. Dadurch kann zumindest weitgehend verhindert werden, dass Störsingale von der wenigstens einen Antriebseinheit auf das Bauteil übertragen werden. Aufgrund der Koppelung der Welle mit der wenigstens einen Antriebseinheit kann das Gehäuse der Antriebseinheit eine Öffnung umfassen. Durch diese Öffnung können Störungen auf die Welle übertragen werden.

Die Vorrichtung umfasst ein Gehäuse, welches einen Spalt zur Aufnahme eines elektrisch leitfähigen Fluides ausbildet. Das Gehäuse kann zwischen der wenigstens einen Antriebseinheit und dem Bauteil angeordnet sein. Insbesondere kann das Gehäuse mit der Öffnung des Gehäuses der wenigstens einen Antriebseinheit in Verbindung stehen und daran anschließen. Das Gehäuse kann einstückig und/oder zweiteilig und/oder mehrteilig ausgebildet sein. Das Gehäuse umfasst zumindest zwei zueinander beabstandete Lagerungen zur drehenden Aufnahme des Bauteils wobei die wenigstens zwei zueinander beabstandeten Lagerungen zur drehenden Aufnahme des Bauteils innerhalb des Gehäuses angeordnet sind.

Das elektrisch leitfähige Fluid dient nicht nur als sinnvolle Erdungsmaßnahme für das drehende Bauteil und ist dadurch geeignet, die Antennenwirkung des Bauteils zu unterbinden, sondern verschließt aufgrund der großflächigen Berührung gleichzeitig eine Öffnung zwischen Gehäuse und rotierendem Bauteil, ohne dass durch die flächige Kontaktierung irgendwelche unerwünschten Verschleißeffekte auftreten können. Die Erfindung verzichtet daher auf einen flächigen Kontakt mit leitfähigem Material, das etwa durch einen Feststoff gebildet wäre, sondern die Antennenwirkung wird dadurch unterbunden, dass die Öffnung zwischen rotierendem Bauteil und Gehäuse durch ein leitfähiges Fluid verschlossen wird. Durch Einbringung und gleichmäßige Verteilung des elektrisch leitfähigen Fluides in den Bereich der Öffnung, bspw. in einen Spalt oder Ringspaltes, wird der Durchtritt von elektromagnetischen Wellen effektiv verhindert. Die Wellenlagerungen selbst bilden normalerweise keine definierte Erdung. Das in den Spalt oder Ringspalt eingebrachte elektrisch leitfähige Fluid verschließt den Spalt oder Ringspalt und verbindet die Welle mit dem Gehäuse in elektrisch leitender Weise. Das Fluid erzeugt und/oder überträgt keine Erwärmung und unterliegt darüber hinaus keinem Verschleiß. Es muss nur dafür gesorgt werden, dass ständig ausreichende Mengen an dem Fluid vorhanden sind.

Das Gehäuse kann eine durchgehende Öffnung umfassen, in welche die Welle aufgenommen werden kann. Die eine durchgehende Öffnung kann zentral und/oder dezentral an einer Stirnseite des Gehäuses angeordnet sein. Die durchgehende Öffnung kann einen zylindrischen und/oder einen quadratischen und/oder einen rechteckigen Querschnitt und/oder dergleichen aufweisen. Zwischen der zumindest einen Öffnung und der Welle kann der Spalt zur Aufnahme eines elektrisch leitfähigen Fluides ausgebildet sein.

Die Vorrichtung umfasst weiter eine Einrichtung zum Erfassen und/oder Feststellen einer Ist-Beschaffenheit und Überprüfen der erfassten und/oder festgestellten Ist-Beschaffenheit auf Übereinstimmung mit einer vorgegebenen Soll-Beschaffenheit.

Die Einrichtung kann die elektromagnetische Verträglichkeit des Bauteils erfassen und/oder feststellen, d.h. die Einrichtung kann die elektromagnetische Verträglichkeit über das Erfassen und/oder Feststellen der Ist-Beschaffenheit des Bauteils charakterisieren. Die Soll-Beschaffenheit eines Bauteils kann durch den Anwender und/oder dergleichen vorgegeben werden. Die Einrichtung kann dazu ausgebildet sein, einen Vergleich der Ist-Beschaffenheit mit der Soll-Beschaffenheit in Bezug auf die elektromagnetische Verträglichkeit des Bauteils durchzuführen. Die Einrichtung kann eine Ausgabeeinheit umfassen, mittels welcher die Ist-Beschaffenheit des Bauteils grafisch und/oder digital und/oder dergleichen ausgegeben werden kann. Die Ausgabeeinheit kann als PC und/oder als Tablet und/oder als Smartphone und/oder dergleichen ausgebildet sein.

Gemäß der Vorrichtung ist der Spalt derart positioniert, dass eine elektrisch leitende Verbindung zwischen dem jeweiligen über die wenigstens zwei zueinander beabstandeten Lagerungen aufgenommenen Bauteil und dem Gehäuse mittels des elektrisch leitfähigen Fluides hergestellt werden kann.

Der Spalt kann zumindest bereichsweise zwischen der Öffnung des Gehäuses und der Welle ausgebildet sein; d.h. der Spalt kann sich zumindest bereichsweise entlang der Längserstreckungsrichtung der Welle erstrecken, welcher Spalt zur Aufnahme eines elektrisch leitfähigen Fluides ausgebildet ist.

Der Spalt kann vollständig zwischen der Öffnung des Gehäuses und der Welle ausgebildet sein, d.h. der Spalt sich vollständig entlang der Längserstreckungsrichtung der Welle erstrecken, welcher Spalt zur Aufnahme eines elektrisch leitfähigen Fluides ausgebildet ist.

Durch das elektrisch leitfähige Fluid kann sich der zumindest bereichsweise entlang der Längserstreckungsrichtung der Welle erstreckende Spalt oder der vollständig entlang der Längserstreckungsrichtung der Welle erstreckende Spalt zwischen dem Gehäuse und der Welle nahezu verschlossen werden. Es können Störungen, die über die Welle aus der Antriebseinheit auf das zu prüfende Bauteil übertragen werden, zumindest weitgehend unterbunden werden. Die Störungen können über die ausgebildete elektrisch leitende Verbindung zwischen dem jeweiligen über die wenigstens zwei zueinander beabstandeten Lagerungen aufgenommenen Bauteil und dem Gehäuse an die Umgebung abgegeben werden. Dadurch kann das Bauteil von Störungen der wenigstens einen Antriebseinheit zumindest weitgehend geschützt werden. Das elektrische leitfähige Fluid weist denjenigen Vorteil auf, dass es selbst keine Erwärmung erzeugt.

Gemäß einer Weiterbildung der Erfindung kann sich der Spalt zumindest bereichsweise und/oder vollständig entlang des Umfangsverlaufes der Welle erstrecken. Eine Kombination des zumindest bereichsweisen und/oder vollständig entlang des Umfangsverlaufes der Welle erstreckenden Spaltes mit einem sich zumindest bereichsweisen und/oder vollständig entlang der Längserstreckungsrichtung der Welle erstreckenden Spaltes kann beliebig möglich sein.

So kann sich der Spalt zumindest bereichsweise entlang des Umfangsverlaufes der Welle und zumindest bereichsweise und/oder vollständig entlang der Längserstreckungsrichtung der Welle erstrecken.

Gemäß einer Weiterbildung der Erfindung kann sich der Spalt vollständig entlang des Umfangsverlaufes der Welle und zumindest bereichsweise und/oder vollständig entlang der Längserstreckungsrichtung der Welle erstrecken.

Gemäß einer Weiterbildung der Erfindung kann der Spalt als Ringspalt ausgebildet sein. Vorzugsweise kann der Spalt oder Ringspalt einen annähernd zylindrischen Querschnitt sowie eine über seine Längserstreckungsrichtung annähernd hohlzylindrische Innenkontur aufweisen, so dass bei einer zylindrischen Welle mit korrespondierendem Außendurchmesser ein gleichmäßiger Ringspalt über die Länge der Welle bzw. zumindest über den Bereich zwischen den beiden Lagerungen zur Verfügung gestellt wird.

Es kann vorgesehen sein, dass das Gehäuse zumindest eine sich bis zum Spalt erstreckende Öffnung umfasst. Die zumindest eine sich bis zum Spalt erstreckende Öffnung kann nahezu senkrecht in Bezug auf den Spalt ausgebildet sein. Alternativ kann die zumindest eine sich bis zum Spalt erstreckende Öffnung in Bezug auf den Spalt einen Winkel einschließen. Die zumindest eine sich bis zum Spalt erstreckende Öffnung kann einen zylindrischen und/oder einen quadratischen und/oder einen rechteckigen Querschnitt ausbilden. Vorzugsweise kann die zumindest eine sich bis zum Spalt erstreckende Öffnung eine Bohrung ausbilden. Ein Durchmesser der zumindest einen sich bis zum Spalt erstreckenden Öffnung kann zumindest gleichbleibend und/oder konisch ausgebildet sein.

Die Erfindung kann vorsehen, dass die zumindest eine sich bis zum Spalt erstreckende Öffnung zur Zufuhr des elektrisch leitfähigen Fluides ausgebildet ist; d.h. über die zumindest eine sich bis zum Spalt erstreckende Öffnung kann der Spalt mit dem elektrisch leitfähigen Fluid versorgt werden.

Gemäß einer Weiterbildung der Erfindung kann das Gehäuse zumindest eine weitere sich bis zum Spalt erstreckende Öffnung umfassen. Die zumindest eine weitere sich bis zum Spalt erstreckende Öffnung kann seitlich versetzt bzw. beabstandet zur wenigstens einen sich bis zum Spalt erstreckenden Öffnung oder auf einer gegenüberliegenden Seite der wenigstens einen sich bis zum Spalt erstreckenden Öffnung angeordnet sein. Vorzugsweise kann die zumindest eine weitere sich bis zum Spalt erstreckende Öffnung auf einer gegenüberliegenden Seite der wenigstens einen sich bis zum Spalt erstreckenden Öffnung angeordnet sein und direkt gegenüber und oder seitlich versetzt zu dieser angeordnet sein; d.h. eine Achse der zumindest einen sich bis zum Spalt erstreckenden Öffnung sowie eine Achse der zumindest einen weiteren sich bis zum Spalt erstreckenden Öffnung liegen auf einer Ebene. Wahlweise kann das Fluid ständig mittels der Öffnungen in Zirkulation gehalten werden, so dass ggf. entstehende Wärmeübertragungseffekte verhindert oder ausgeglichen werden können, bspw. durch eine zusätzliche externe Kühlung im Fluidkreislauf.

Zugleich kann die zumindest eine weitere sich bis zum Spalt erstreckende Öffnung nahezu senkrecht in Bezug auf den Spalt ausgebildet sein oder einen Winkel in Bezug auf den Spalt einschließen. Die zumindest eine weitere sich bis zum Spalt erstreckende Öffnung kann einen zylindrischen und/oder einen quadratischen und/oder einen rechteckigen Querschnitt ausbilden. Vorzugsweise kann die zumindest eine weitere sich bis zum Spalt erstreckende Öffnung eine Bohrung ausbilden. Ein Durchmesser der zumindest einen weiteren sich bis zum Spalt erstreckenden Öffnung kann zumindest gleichbleibend und/oder konisch ausgebildet sein.

Es kann vorgesehen sein, dass die zumindest eine weitere sich bis zum Spalt erstreckende Öffnung zur Entlüftung des Gehäuses ausgebildet ist. Mittels der zumindest einen weiteren sich bis zum Spalt erstreckenden Öffnung kann überschüssige Luft aus dem Spalt zwischen dem Gehäuse und der Welle abgelassen werden.

Die wenigstens eine weitere sich bis zum Spalt erstreckende Öffnung kann auch dazu dienen, überschüssiges elektrisch leitfähiges Fluid und/oder das elektrisch leitfähige Fluid nach der Überprüfung des Bauteils auf Vorhandensein einer Soll-Beschaffenheit abzulassen. Das Gehäuse kann eine separate sich bis zum Spalt erstreckende Öffnung umfassen, mittels welcher das überschüssige oder nicht mehr benötigte elektrisch leitfähige Fluid abgelassen werden kann. Die Vorrichtung kann einen Auffangbehälter zur Aufnahme des überschüssigen und/der des abgelassenen elektrisch leitfähigen Fluides umfassen.

Gemäß einer Weiterbildung der Erfindung kann die Vorrichtung einen Speicher für das elektrisch leitfähige Fluid umfassen, welcher Speicher mit dem Spalt in fluidischer Verbindung steht. Die fluidische Verbindung kann durch eine Leitung und/oder einen Schlauch und/oder dergleichen gebildet sein, welche das elektrisch leitfähige Fluid aus dem Speicher über die zumindest eine sich bis zum Spalt erstreckende Öffnung in den Spalt zuführt. Der fluidischen Verbindung kann eine Fördereinrichtung, beispielsweise in Form einer Pumpe und/oder dergleichen, zur Beförderung des elektrisch leitfähigen Fluides zugeordnet sein. Dem Speicher und/oder der fluidischen Verbindung kann zumindest ein Ventil zugeordnet sein, welches die Zufuhr des elektrisch leitfähigen Fluides aus dem Speicher in den Spalt steuert. Das zumindest eine Ventil kann an einer Öffnung des Speichers zu einer Leitung und/oder einem Schlauch und/oder dergleichen angeordnet sein. Alternativ kann das zumindest eine Ventil innerhalb der fluidischen Verbindung, insbesondere innerhalb einer Leitung und/oder eines Schlauches und/oder dergleichen, angeordnet sein.

Zur Lösung der genannten Aufgaben sieht die Erfindung weiter ein Verfahren zum Überprüfen eines Bauteils auf Vorhandensein einer vorgegebenen Soll-Beschaffenheit vor.

In einem ersten Schritt erfolgt eine Lagerung eines Bauteils, wobei das Bauteil zumindest abschnittsweise in ein Gehäuse hineinragt. Bei dem Bauteil kann es sich um Antriebe jeglicher Art handeln. Insbesondere kann es sich bei dem Bauteil um einen Hybridantrieb eines Personenkraftwagens handeln.

In einem weiteren Schritt erfolgt ein drehender Antrieb des gelagerten und zumindest abschnittsweise in das Gehäuse hineinragenden Bauteils. Das Bauteil kann von wenigstens einer Antriebseinheit über eine Welle zu einer Drehbewegung mit einem definierten Moment und mit einer definierten Leistung angetrieben oder gebremst werden.

In einem weiteren Schritt erfolgt das Erfassen und/oder Feststellen einer Ist-Beschaffenheit des Bauteils zeitlich während des drehenden Antriebs und Überprüfen der jeweiligen erfassten und/oder festgestellten Ist-Beschaffenheit auf Übereinstimmung mit einer vorgegebenen Soll-Beschaffenheit. Es kann die elektromagnetische Verträglichkeit des Bauteils gemessen und charakterisiert werden. Dabei kann die erfasste und/oder festgestellte Ist-Beschaffenheit auf eine Soll-Beschaffenheit überprüft werden sowie miteinander verglichen werden. Die erfasste und/oder festgestellte Ist-Beschaffenheit kann grafisch und/oder digital und/oder dergleichen ausgegeben werden.

Das Verfahren sieht vor, dass zumindest während des Erfassens und/oder Feststellens der Ist-Beschaffenheit ein Fluid durch Oberflächenkontakt eine elektrisch leitfähige Verbindung zwischen dem gelagerten Bauteil und dem Gehäuse herstellt. Das elektrisch leitfähige Fluid wird in einen Spalt zwischen dem Gehäuse und der Welle eingebracht. Aufgrund der elektrisch leitenden Verbindung können Störungen, die von der Welle übertragen werden können, sowie der Spalt des Gehäuses zwischen dem Gehäuse und der Welle verschlossen werden. Die Störungen können über die elektrisch leitende Verbindung zwischen dem gelagerten Bauteil und dem Gehäuse an die Umgebung abgegeben werden. Dadurch kann das Bauteil von Störungen der wenigstens einen Antriebseinheit zumindest weitgehend geschützt werden.

Es kann vorgesehen sein, dass ein Spalt des Gehäuses zumindest während des Erfassens und/oder Feststellens der Ist-Beschaffenheit des Bauteils permanent mit einem elektrisch leitfähigen Fluid versorgt wird. Das elektrisch leitfähige Fluid kann aus einem Speicher entnommen werden und dem Spalt entsprechend zugeführt werden. Bei einer permanenten Zuführung des elektrisch leitfähigen Fluides kann das zumindest eine Ventil geöffnet werden. Zumindest nach Beendigung des Erfassens und/oder Feststellens der Ist-Beschaffenheit des Bauteils kann das zumindest eine Ventil geschlossen werden.

Es kann vorgesehen sein, dass ein Spalt des Gehäuses zumindest während des Erfassens und/oder Feststellens der Ist-Beschaffenheit des Bauteils zyklisch mit einem elektrisch leitfähigen Fluid versorgt wird. Das elektrisch leitfähige Fluid kann aus einem Speicher entnommen werden und dem Spalt entsprechend zugeführt werden. Bei einer zyklischen Zuführung des elektrisch leitfähigen Fluides kann das zumindest eine Ventil in bestimmten Zeitabständen geöffnet oder geschlossen werden.

Gemäß einer Weiterbildung der Erfindung kann zumindest während des Erfassens und/oder Feststellens der Ist-Beschaffenheit des Bauteils eine elektromagnetische Welle den Spalt passieren.

Sofern ein neues Bauteil auf seine Ist-Beschaffenheit in Bezug auf eine vorgegebene Soll-Beschaffenheit geprüft werden soll, kann das Verfahren von vorne beginnen.

Einige Aspekte der vorliegenden Erfindung sollen nachfolgend nochmals anhand möglicher bzw. besonders zweckmäßiger Ausführungsvarianten, welche sich vorrangig auf eine Durchführung für rotierende Bauteile wie bspw. schnell drehende Wellen beziehen, erläutert werden. Bei durchzuführenden Prüfungen auf elektromagnetische Verträglichkeit (sog. EMV oder EMV-Prüfung) müssen rotierende Prüflinge, die Drehmomente bzw. Leistungen übertragen sollen, überprüft werden. Solche Prüflinge können bspw. Hybridantriebe für Kraftfahrzeuge oder Teile von solchen Hybridantrieben sein. Um eine möglichst realitätsgetreue und damit für die Praxis verwertbare Prüfung durchführen und/oder nachstellen zu können, muss der Prüfling bei einem solchen Prüfdurchlauf nicht nur mit konstanter Drehzahl rotieren, sondern im Prüfungsverlauf auch gebremst oder angetrieben werden. Während der Prüfung wird die Aussendung von Störungen vom Prüfling (Störaussendung) als auch die Unempfindlichkeit gegenüber von außen einwirkende Störungen auf den Prüfling (Störfestigkeit) überprüft.

Um eine solche Prüfung durchführen zu können, muss der Prüfling während der Prüfung mit einem definierten Drehmoment bei definierter Drehzahl bzw. mit variablem Drehmoment und/oder variabler Drehzahl beaufschlagt werden, was mit einer geeigneten Antriebseinheit erfolgen kann. Normalerweise werden solche Prüfungen in speziellen Hallen (sog. EMV-Kammern) durchgeführt. Diese sind als faradayscher Käfig ausgeführt, so dass von außen keine elektromagnetischen Störungen in die Halle eindringen und zudem keine elektromagnetischen Störungen die Halle verlassen können.

Die Antriebseinheit selbst befindet sich normalerweise innerhalb der Halle; der Prüfling ist mit dieser Einheit mechanisch gekoppelt. Die Antriebseinheit selbst besitzt ebenfalls einen Antriebsmotor und eine Leistungselektronik, die jeweils für sich in der Lage sind, elektromagnetische Störungen zu verursachen. Da die Störungen der Antriebseinheit potentiell dazu geeignet sind, die Prüfung zu beeinflussen - denn es soll der Prüfling isoliert getestet werden, und nicht die den Prüfling antreibende Antriebseinheit oder die Baueinheit aus Prüfling und Antriebseinheit -, muss die Antriebseinheit nicht nur störfrei, sondern auch störfest sein. Beides kann dadurch erreicht werden, dass auch die Antriebseinheit selbst als faradayscher Käfig ausgeführt wird, in den elektrische Energie eingespeist und aus dem mechanische Energie abgeführt bzw. in umgekehrter Richtung mechanische Energie eingespeist und elektrische Energie abgeführt wird. In beide Energieflussrichtungen sollen keine Störungen verursacht werden.

Da jede Öffnung oder jeder Schlitz in einem faradayschen Käfig grundsätzlich dazu führen kann, dass Strahlungsenergie eingebracht bzw. emittiert wird, sind jegliche Öffnungen zu vermeiden. Da aber eine Drehbewegung ausgeführt wird, für deren Auslösung eine drehende Kraftübertragung erforderlich ist, muss zwangsläufig eine Öffnung zwischen stehenden und drehenden Teilen vorhanden sein. Drehende Teile sind zudem notwendigerweise gelagert. Diese Lagerungen führen gleichzeitig zu einer Isolation des drehenden Bauteiles. Da das drehende Bauteil in den störbehafteten Innenraum der Antriebseinheit ragt, kann die meist länglich ausgeführte, drehende Welle als Antenne fungieren, auf welche die inneren Störungen aufgekoppelt werden, so dass die Störungen mittels der Antenne nach außen abgestrahlt werden können. Daher ist es sinnvoll, sowohl diese Öffnung zu vermeiden, als auch die Antennenwirkung der drehenden Wellenteile zu unterbinden.

Dies ist jedoch nur durch geeignete Erdungsmaßnahmen und durch ein Verschließen der Öffnungen möglich, also durch flächigen Kontakt der drehenden Teile mit leitfähigem Material. Die erfindungsgemäßen Maßnahmen sehen eine großflächige Berührung vor, um die Antenne zu "zerstören" und um die Öffnung zu verschließen. Diese flächige Berührung (meist metallisch federnde Werkstoffe) ist jedoch bei hohen Drehzahlen schädlich und auch verschleißbehaftet. Darum sieht die Erfindung nicht den aus dem Stand der Technik bekannten flächigen Kontakt mit leitfähigem Material vor, das durch einen Feststoff gebildet ist, sondern die Antennenwirkung soll dadurch unterbunden werden, dass die Öffnung durch ein leitfähiges Fluid verschlossen wird.

Die Wellendurchführung kann bspw. in einer Weise ausgeführt sein, dass die Antriebswelle durch eine lange Bohrung, die nur geringfügig größer ist als die Welle, hindurchgeführt wird. In Nähe ihrer beiden Enden bzw. Stirnseiten kann die Welle gelagert werden. Durch Ausbildung eines Ringspaltes wird der Durchtritt von elektromagnetischen Wellen verhindert. Die Wellenlagerungen selbst bilden keine definierte Erdung. In den Ringspalt wird ein elektrisch leitfähiges Fluid eingebracht, das diesen Ringspalt verschließt und die Welle mit dem Gehäuse elektrisch leitend verbindet. Das Fluid erzeugt und/oder überträgt keine Erwärmung und unterliegt darüber hinaus keinem Verschleiß. Es muss nur dafür gesorgt werden, dass ständig ausreichende Mengen an dem Fluid vorhanden sind.

Im Folgenden sollen Ausführungsbeispiele die Erfindung und ihre Vorteile anhand der beigefügten Zeichnung näher erläutern. Die Größenverhältnisse der einzelnen Elemente zueinander in den Figuren der beigefügten Zeichnung entsprechen nicht immer den realen Größenverhältnissen, da einige Formen vereinfacht und andere Formen zur besseren Veranschaulichung vergrößert im Verhältnis zu anderen Elementen dargestellt sind.
Fig. 1 zeigt einen Längsschnitt eines Teils der Vorrichtung zum Überprüfen eines Bauteils auf Vorhandensein einer vorgegebenen Soll-Beschaffenheit.
Fig. 2 zeigt ein schematisches Ablaufdiagramm zum Verfahren zum Überprüfen des Bauteils auf Vorhandensein einer vorgegebenen Soll-Beschaffenheit.

Für gleiche oder gleich wirkende Elemente der Erfindung werden identische Bezugszeichen verwendet. Ferner werden der Übersicht halber nur Bezugszeichen in den einzelnen Figuren dargestellt, die für die Beschreibung der jeweiligen Figur erforderlich sind. Die dargestellten Ausführungsformen stellen lediglich Beispiele dar, wie die erfindungsgemäße Rahmenkonstruktion, das erfindungsgemäße Verfahren oder die erfindungsgemäße landwirtschaftliche Maschine ausgestaltet sein können und stellen keine abschließende Begrenzung dar.

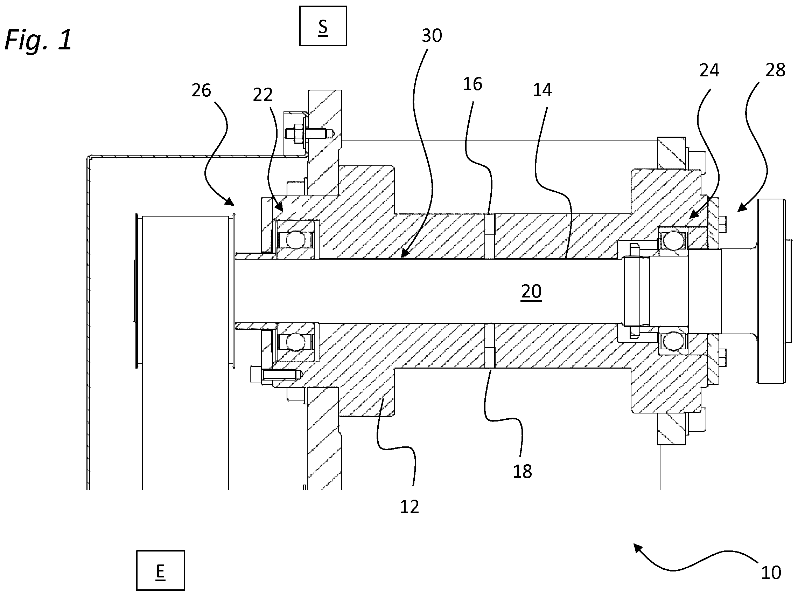

Der schematische Längsschnitt der Fig. 1 zeigt einen Ausschnitt der erfindungsgemäßen Vorrichtung 10 zum Überprüfen eines Bauteils (hier nicht vollständig dargestellt) auf Vorhandensein einer vorgegebenen Soll-Beschaffenheit. Bei dem Bauteil kann es sich bspw. um einen Teil eines Hybridantriebes eines Kraftfahrzeuges bzw. eines Personenkraftwagens handeln. Das Bauteil umfasst eine drehbare Welle 20, welche von wenigstens zwei zueinander beabstandeten Lagerungen, insbesondere gebildet durch eine erste Lagerung 22 (hier links im Bild) und durch eine zweite Lagerung 24 (hier rechts im Bild), getragen und um ihre Wellenachse drehbar gelagert wird. Die erste Lagerung 22 und die zweite Lagerung 24 dienen der weitgehend spielfreien drehenden Aufnahme und Lagerung des Bauteils, insbesondere der Welle 20, sowie der axialen Festlegung der Welle 20 gegen unerwünschtes axiales Verschieben.

Die Lagerungen 22 und 24 sind in der gezeigten Ausführungsvariante jeweils als Wälzlagerungen ausgebildet; grundsätzlich können auch andere Lagerungen eingesetzt werden, doch sind Wälzlagerungen besonders zweckmäßig.

Die in der Lagerungen 22 und 24 drehbar gelagerte Welle 20 ist mit wenigstens einer Antriebseinheit (hier nicht dargestellt) gekoppelt, über welche die Welle 20 und damit das Bauteil mit einem definierten Moment und einer definierten Leistung bei definierten Drehzahlen angetrieben oder gebremst werden kann. Die wenigstens eine Antriebseinheit bzw. ein Gehäuse der wenigstens einen Antriebseinheit ist als faradayscher Käfig ausgebildet. Das Gehäuse der wenigstens einen Antriebseinheit benötigt aufgrund der Koppelung mit der Welle 20 eine Öffnung. Um die Übertragung von elektromagnetischen Störungen von der wenigstens einen Antriebseinheit auf die Welle 20 und/oder auf das gesamte Bauteil zumindest weitestgehend zu unterbinden, umfasst die Vorrichtung 10 ein Gehäuse 12. Das Gehäuse 12 ist zwischen der wenigstens einen Antriebseinheit und dem zu überprüfenden Bauteil angeordnet und fungiert zumindest abschnittsweise als Verbindungselement zwischen der wenigstens einen Antriebseinheit und dem zu prüfenden Bauteil. Das Gehäuse 12 bildet einen Spalt 14 oder Ringspalt 14 zur Aufnahme eines elektrisch leitfähigen Fluides aus. Hierzu umfasst das Gehäuse 12 eine durchgehende Öffnung 30, welche auf einer Stirnseite des Gehäuses 12 zentral angeordnet ist. Die durchgehende Öffnung 30 dient dazu, die Welle 20 aufzunehmen. Die durchgehende Öffnung 30 ist hohlzylindrisch und weist einen Durchmesser auf, der etwas größer ist als der Außendurchmesser der Welle 20.

Der Spalt 14 des Gehäuses 12 ist dabei derart positioniert, dass eine elektrisch leitende Verbindung zwischen dem jeweiligen über die wenigstens zwei zueinander beabstandeten Lagerungen, gebildet durch die erste Lagerung 22 und die zweite Lagerung 24, aufgenommenen Bauteil und dem Gehäuse 12 mittels des elektrisch leitfähigen Fluides hergestellt werden kann.

Der Spalt 14 ist vorzugsweise als Ringspalt ausgebildet und erstreckt sich vollständig entlang des Umfangsverlaufes und vollständig entlang der Längserstreckungsrichtung der Welle 20; d.h. der Spalt 14 wird zwischen der Welle 20 und der durchgehenden Öffnung 30 gebildet. Durch das elektrisch leitfähige Fluid wird der Spalt 14 zwischen dem Gehäuse 12 und der Welle 20 nahezu verschlossen. Zugleich wird die Antennenwirkung der Welle 20 unterbunden; d.h. Störungen, die über die Welle 20 von der wenigstens einen Antriebseinheit auf das zu prüfende Bauteil übertragen werden, werden zumindest weitgehend unterbunden und über das Gehäuse 12 an die Umgebung abgeleitet.

Das elektrisch leitfähige Fluid ist in einem in Figur 1 lediglich schematisch angedeuteten Speicher S gelagert und wird über eine entsprechende Leitung (hier nicht dargestellt) dem Spalt 14 über zumindest eine sich bis zum Spalt 14 erstreckende Öffnung 16 wahlweise permanent oder zyklisch zugeführt. Dem Speicher S, insbesondere einer mit der Leitung in Verbindung stehenden Öffnung des Speichers S, ist zumindest ein Ventil (hier nicht dargestellt) zugeordnet, mittels welchem die Zufuhr des elektrisch leitfähigen Fluides gesteuert werden kann. Die Leitung führt zu zumindest einer sich bis zum Spalt 14 erstreckenden Öffnung 16.

Die zumindest eine sich bis zum Spalt 14 erstreckende Öffnung 16 ist als Bohrung ausgebildet und verläuft in Bezug auf die durchgehende Öffnung 30 bzw. auf den Spalt 14 nahezu senkrecht. Auf einer gegenüberliegenden Seite der zumindest einen sich bis zum Spalt 14 erstreckenden Öffnung 16 ist zumindest eine weitere sich bis zum Spalt 14 erstreckende Öffnung 18 vorgesehen; d.h. eine Achse der zumindest einen sich bis zum Spalt 14 erstreckenden Öffnung 16 und eine Achse der zumindest einen weiteren sich bis zum Spalt 14 erstreckenden Öffnung 18 liegen auf einer Ebene. Die zumindest eine weitere sich bis zum Spalt 14 erstreckende Öffnung 18 ist zur Entlüftung der durchgehenden Öffnung 30 des Gehäuses 12 vorgesehen.

Das Gehäuse 12 ist vorzugsweise einstückig ausgebildet und mittels einer ersten Befestigungseinheit 26 und einer zweiten Befestigungseinheit 28 zwischen der Antriebseinheit und dem Bauteil befestigt. Innerhalb des Gehäuses 12 sind zudem die erste Lagerung 22 und die zweite Lagerung 24 angeordnet.

Die Vorrichtung 10 umfasst weiter eine Einrichtung E zum Erfassen und/oder Feststellen einer Ist-Beschaffenheit und Überprüfen der erfassten und/oder festgestellten Ist-Beschaffenheit auf Übereinstimmung mit einer vorgegebenen Soll-Beschaffenheit. Bei der Einrichtung E erfolgt eine Messung bzw. Prüfung der elektromagnetischen Verträglichkeit des Bauteils. Durch das Erfassen und/oder Feststellen einer Ist-Beschaffenheit ist ein Soll-Ist-Wert-Vergleich der erfassten und/oder festgestellten Ist-Beschaffenheit auf eine vorgegebene Soll-Beschaffenheit möglich. Es kann festgestellt werden, ob das Bauteil den Anforderungen, insbesondere einer Soll-Beschaffenheit im Rahmen der elektromagnetischen Verträglichkeit, entspricht.

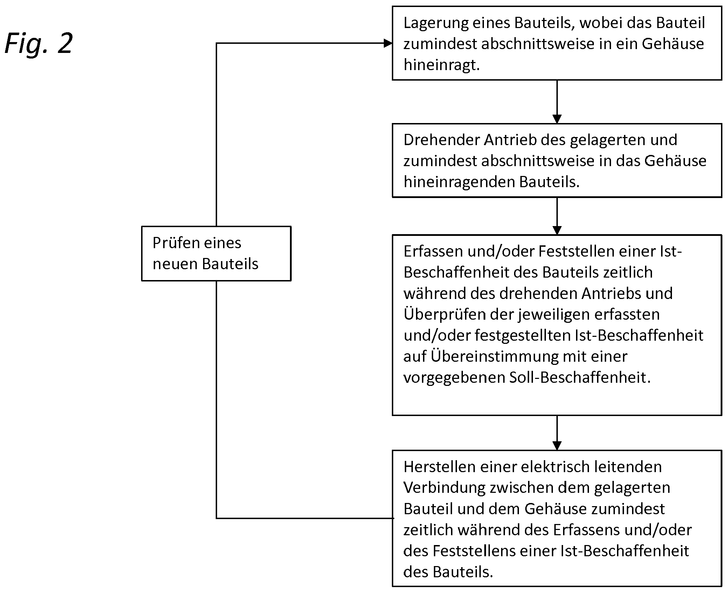

Die Fig. 2 verdeutlicht anhand eines schematischen Blockschaltbildes aufeinanderfolgende Schritte eines erfindungsgemäßen Verfahrens, mittels welchem ein Bauteil auf Vorhandensein einer vorgegebenen Soll-Beschaffenheit überprüft wird.

Gemäß dem Verfahren erfolgt zunächst eine Lagerung eines Bauteils, wobei das Bauteil zumindest abschnittsweise in ein Gehäuse 12 hineinragt. Bei dem Bauteil handelt es sich um einen Hybridantrieb eines Personenkraftwagens. Das Bauteil umfasst eine Welle 20, welche von wenigstens zwei zueinander beabstandeten Lagerungen, insbesondere gebildet durch eine erste Lagerung 22 und durch eine zweite Lagerung 24, getragen wird.

In einem weiteren Schritt erfolgt ein drehender Antrieb des gelagerten und zumindest abschnittsweise in das Gehäuse 12 hineinragenden Bauteils. Dabei wird die Welle 20 mit einem definierten Moment und mit einer definierten Leistung angetrieben oder gebremst.

Anschließend folgt das Erfassen und/oder Feststellen einer Ist-Beschaffenheit des Bauteils zeitlich während des drehenden Antriebs und Überprüfen der jeweiligen erfassten und/oder festgestellten Ist-Beschaffenheit auf Übereinstimmung mit einer vorgegebenen Soll-Beschaffenheit. Dabei wird die elektromagnetische Verträglichkeit des Bauteils gemessen und charakterisiert. Die gemessene Ist-Beschaffenheit wird mit einer vorgegebenen Soll-Beschaffenheit verglichen und auf Abweichungen untersucht. Die erfasste und/oder festgestellte Ist-Beschaffenheit des Bauteils wird digital ausgegeben.

Zumindest während des Erfassens und/oder Feststellens der Ist-Beschaffenheit wird in einen Spalt 14 des Gehäuses 12 ein elektrisch leitfähiges Fluid eingebracht, welches durch Oberflächenkontakt eine elektrisch leitende Verbindung zwischen dem gelagerten Bauteil und dem Gehäuse 12 herstellt. Mittels des elektrisch leitfähigen Fluides wird der Spalt 14 zwischen dem Gehäuse 12 und der Welle 20 verschlossen. Zugleich werden Störungen über die aufgebraute elektrisch leitende Verbindung zwischen dem gelagerten Bauteil und dem Gehäuse 12 an die Umgebung abgegeben. Dadurch ist das Bauteil vor ungewollten Störungen zumindest weitgehend geschützt und es passiert zumindest während des Erfassens und/oder Feststellens der Ist-Beschaffenheit des Bauteiles eine elektromagnetische Welle den Spalt 14.

Das elektrisch leitfähige Fluid wird zumindest während des Erfassens und/oder Feststellens der Ist-Beschaffenheit des Bauteils wahlweise permanent oder zyklisch mit einem elektrisch leitfähigen Fluid versorgt. Hierzu wird zumindest ein Ventil angesteuert, welches eine fluidische Verbindung zwischen einem Speicher für das elektrisch leitfähige Fluid und dem Spalt 14 permanent oder zyklisch freigibt oder sperrt.

Sofern ein neues Bauteil auf seine Ist-Beschaffenheit in Bezug auf eine vorgegebene Soll-Beschaffenheit geprüft werden soll, beginnt das Verfahren von vorne.

### Bezugszeichenliste

- 10: Vorrichtung
- 12: Gehäuse
- 14: Spalt, Ringspalt
- 16: sich bis zum Spalt erstreckende Öffnung
- 18: weitere sich bis zum Spalt erstreckende Öffnung
- 20: Welle
- 22: erste Lagerung
- 24: zweite Lagerung
- 26: erste Befestigungseinheit
- 28: zweite Befestigungseinheit
- 30: durchgehende Öffnung

- E: Einrichtung, Einrichtung zum Erfassen und/oder Feststellen einer Ist-Beschaffenheit, Einrichtung zum Überprüfen der erfassten und/oder festgestellten Ist-Beschaffenheit auf Übereinstimmung mit einer vorgegebenen Soll-Beschaffenheit
- S: Speicher

## Patentansprüche

1. Vorrichtung (10) zum Überprüfen eines Bauteils auf Vorhandensein einer vorgegebenen Soll-Beschaffenheit, die Vorrichtung umfassend
- wenigstens zwei zueinander beabstandete Lagerungen (22, 24) zur Aufnahme und drehbaren Lagerung des Bauteils,
**gekennzeichnet durch**
- ein elektrisch leitfähiges Fluid,
- ein Gehäuse (12), welches einen Spalt (14) zur Aufnahme des elektrisch leitfähigen Fluides ausbildet, wobei die wenigstens zwei zueinander beabstandeten Lagerungen (22, 24) zur drehenden Aufnahme des Bauteils innerhalb des Gehäuses (12) angeordnet sind, sowie
- eine Einrichtung zum Erfassen und/oder Feststellen einer Ist-Beschaffenheit und Überprüfen der erfassten und/oder festgestellten Ist-Beschaffenheit auf Übereinstimmung mit einer vorgegebenen Soll-Beschaffenheit, wobei
der Spalt (14) derart positioniert ist, dass eine elektrisch leitende Verbindung zwischen dem jeweiligen über die wenigstens zwei zueinander beabstandeten Lagerungen aufgenommenen Bauteil und dem Gehäuse (12) mittels des elektrisch leitfähigen Fluides hergestellt ist.

2. Vorrichtung nach Anspruch 1, bei welcher der Spalt (14) als Ringspalt ausgebildet ist.

3. Vorrichtung nach Anspruch 2, bei welcher der Ringspalt einen zylindrischen Querschnitt sowie eine hohlzylindrische Innenkontur aufweist.

4. Vorrichtung nach einem der Ansprüche 1 bis 3, bei welcher das Gehäuse (12) zumindest eine sich bis zum Spalt (14) erstreckende Öffnung (16) umfasst.

5. Vorrichtung nach Anspruch 4, bei welcher die zumindest eine sich bis zum Spalt (14) oder Ringspalt erstreckende Öffnung (16) zur Zufuhr des elektrisch leitfähigen Fluides ausgebildet ist.

6. Vorrichtung nach Anspruch 4 oder 5, bei welcher das Gehäuse (12) zumindest eine weitere sich bis zum Spalt (14) erstreckende Öffnung (18) umfasst.

7. Vorrichtung nach Anspruch 6, bei welcher die zumindest eine weitere sich bis zum Spalt (14) erstreckende Öffnung (18) zur Entlüftung des Gehäuses (12) ausgebildet ist.

8. Vorrichtung nach einem der vorherigen Ansprüche, welche einen Speicher (S) für das elektrisch leitfähige Fluid umfasst, welcher Speicher (S) mit dem Spalt in fluidischer Verbindung steht.

9. Verfahren zum Überprüfen eines Bauteils auf Vorhandensein einer vorgegebenen Soll-Beschaffenheit unter Verwendung der Vorrichtung nach einem der Ansprüche 1-8, das Verfahren umfassend folgende Schritte:
- Lagerung des Bauteils, wobei das Bauteil zumindest abschnittsweise in das Gehäuse (12) hineinragt, wobei die wenigstens zwei zueinander beabstandeten Lagerungen (22, 24) zur drehenden Aufnahme des Bauteils innerhalb des Gehäuses (12) angeordnet sind,
- drehender Antrieb des gelagerten und zumindest abschnittsweise in das Gehäuse (12) hineinragenden Bauteils,
- Erfassen und/oder Feststellen der st-Beschaffenheit des Bauteils zeitlich während des drehenden Antriebs und Überprüfen der jeweiligen erfassten und/oder festgestellten Ist-Beschaffenheit auf Übereinstimmung mit der vorgegebenen Soll-Beschaffenheit, wobei
zumindest während des Erfassens und/oder Feststellens der Ist-Beschaffenheit das Fluid durch Oberflächenkontakt die elektrisch leitende Verbindung zwischen dem gelagerten Bauteil und dem Gehäuse (12) herstellt.

10. Verfahren nach Anspruch 9, bei welchem der Spalt (14) des Gehäuses (12) während des Erfassens und/oder Feststellens der Ist-Beschaffenheit des Bauteils permanent mit dem elektrisch leitfähigen Fluid versorgt wird.

11. Verfahren nach Anspruch 9, bei welchem der Spalt (14) des Gehäuses (12) während des Erfassens und/oder Feststellens der Ist-Beschaffenheit des Bauteils zyklisch mit dem elektrisch leitfähigen Fluid versorgt wird.

12. Verfahren nach einem der Ansprüche 9 bis 11, bei welchem zumindest während des Erfassens und/oder Feststellens der Ist-Beschaffenheit des Bauteils eine elektromagnetische Welle den Spalt (14) passiert.

## Claims

1. A device (10) for checking a component for the presence of a predefined specified condition, the device comprising
- at least two bearings (22, 24) for receiving and rotatably supporting the component, the at least two bearings (22, 24) being spaced apart from each other,
**characterized by**
- an electrically conductive fluid,
- a housing (12), which housing (12) is designed with a gap (14) for receiving the electrically conductive fluid, wherein the at least two bearings (22, 24) for rotatably receiving the component are arranged within the housing (12), which at least two bearings (22, 24) are spaced apart from one another, and
- a device for detecting and/or determining an actual condition and for checking the detected and/or determined actual condition for conformity with a predefined specified condition, wherein
the gap (14) is positioned in such a way, that an electrically conductive connection is established between the respective component received by the at least two spaced-apart bearings and the housing (12) by means of the electrically conductive fluid.

2. The device as recited in claim 1, in which the gap (14) is designed as an annular gap.

3. The device as recited in claim 2, in which the annular gap has a cylindrical cross-section and a hollow cylindrical inner contour.

4. The device as recited in one of the claims 1 to 3, in which the housing (12) comprises at least one opening (16), which opening (16) is extending to the gap (14).

5. The device as recited in claim 4, in which the at least one opening (16), which opening (16) is extending to the gap (14) or to the annular gap, is designed for supplying the electrically conductive fluid.

6. The device as recited in claim 4 or 5, in which the housing (12) comprises at least one further opening (18), which further opening (18) is extending to the gap (14).

7. The device as recited in claim 6, in which the at least one further opening (18), which opening (18) is extending to the gap (14), is provided for the ventilation of the housing (12).

8. The device as recited in one of the previous claims, comprising a reservoir (S) for the electrically conductive fluid, which reservoir (S) is in fluidic communication with the gap.

9. A method of checking a component for the presence of a predefined specified condition using the device according to one of claims 1 to 8, the method comprising the following steps:
- bearing a component, wherein the component projects at least in sections into the housing (12), wherein the at least two bearings (22, 24) for rotatably receiving the component are arranged within the housing (12), which bearings (22, 24) are spaced apart from one another,
- rotary drive of the mounted component projecting at least in sections into the housing (12),
- detecting and/or determining the actual condition of the component temporally during the rotational drive and checking the respective detected and/or determined actual condition for conformity with the predefined specified condition, wherein
at least during the detection and/or determination of the actual condition, the fluid establishes the electrically conductive connection between the mounted component and the housing (12) by surface contact.

10. The method as recited in claim 9, in which the gap (14) of the housing (12) is permanently supplied with the electrically conductive fluid during the detection and/or determination of the actual condition of the component.

11. The method as recited in claim 9, in which the gap (14) of the housing (12) is cyclically supplied with the electrically conductive fluid during the detection and/or determination of the actual condition of the component.

12. The method as recited in one of the claims 9 to 11, in which an electromagnetic wave passes through the gap (14) at least during the detection and/or determination of the actual condition of the component.

## Revendications

1. Dispositif (10) de contrôle d'un composant quant à la présence d'un état exigé prédéterminé, ledit dispositif comprenant
- au moins deux supports (22, 24) espacés les uns par rapport aux autres et destinés à recevoir et à supporter en rotation ledit composant,
**caractérisé par**
- un fluide électriquement conducteur,
- un boîtier (12) qui forme une fente (14) destinée à recevoir le fluide électriquement conducteur, dans lequel lesdits au moins deux supports (22, 24) espacés les uns par rapport aux autres et destinés à recevoir en rotation le composant sont disposés à l'intérieur du boîtier (12), ainsi qu'
- un dispositif destiné à détecter et/ou à constater un état réel et à contrôler l'état réel détecté et/ou constaté quant à la conformité avec un état exigé prédéterminé, dans lequel
ladite fente (14) est positionnée de telle sorte qu'une connexion électriquement conductrice entre le composant respectif reçu par lesdites au moins deux supports espacés les uns par rapport aux autres et le boîtier (12) est établie au moyen du fluide électriquement conducteur.

2. Dispositif selon la revendication 1, dans lequel ladite fente (14) est conçue en tant que fente annulaire.

3. Dispositif selon la revendication 2, dans lequel la fente annulaire présente une section transversale cylindrique ainsi qu'un contour intérieur cylindrique creux.

4. Dispositif selon l'une quelconque des revendications 1 à 3, dans lequel le boîtier (12) comprend au moins une ouverture (16) s'étendant jusqu'à la fente (14).

5. Dispositif selon la revendication 4, dans lequel ladite au moins une ouverture (16) s'étendant jusqu'à la fente (14) ou fente annulaire est conçue pour amener le fluide électriquement conducteur.

6. Dispositif selon la revendication 4 ou 5, dans lequel le boîtier (12) comprend au moins une autre ouverture (18) s'étendant jusqu'à la fente (14).

7. Dispositif selon la revendication 6, dans lequel ladite au moins une autre ouverture (18) s'étendant jusqu'à la fente (14) est conçue pour désaérer le boîtier (12).

8. Dispositif selon l'une quelconque des revendications précédentes, qui comprend un réservoir (S) pour le fluide électriquement conducteur, lequel réservoir (S) est en communication fluidique avec la fente.

9. Procédé de contrôle d'un composant quant à la présence d'un état exigé prédéterminé, en utilisant le dispositif selon l'une quelconque des revendications 1 à 8, le procédé comprenant les étapes suivantes consistant à:-
- supporter le composant, dans lequel le composant fait saillie, au moins par sections, dans le boîtier (12), dans lequel les au moins deux supports (22, 24) espacés les uns par rapport aux autres et destinés à recevoir en rotation le composant sont disposés à l'intérieur du boîtier (12),
- entraîner en rotation le composant supporté et faisant saillie, au moins par sections, dans le boîtier (12),
- détecter et/ou constater l'état réel du composant pendant qu'il est entraîné en rotation, et contrôler l'état réel respectif détecté et/ou constaté quant à la conformité avec l'état exigé prédéterminé, dans lequel
au moins pendant la détection et/ou la constatation de l'état réel, le fluide établit par contact de surface la connexion électriquement conductrice entre le composant supporté et le boîtier (12).

10. Procédé selon la revendication 9, dans lequel la fente (14) du boîtier (12) est alimenté en permanence en fluide électriquement conducteur pendant la détection et/ou la constatation de l'état réel du composant.

11. Procédé selon la revendication 9, dans lequel la fente (14) du boîtier (12) est alimenté de manière cyclique en fluide électriquement conducteur pendant la détection et/ou la constatation de l'état réel du composant.

12. Procédé selon l'une quelconque des revendications 9 à 11, dans lequel une onde électromagnétique passe à travers la fente (14) au moins pendant la détection et/ou la constatation de l'état réel du composant.
